# EUROPÄISCHE PATENTSCHRIFT

(11) **EP 3 275 051 B1**
(45) Veröffentlichungstag und Bekanntmachung des Hinweises auf die Patenterteilung: **18.12.2019**
(21) Anmeldenummer: 16712313.2
(22) Anmeldetag: 23.03.2016
(51) Int. Cl.: H01R 12/71, H01R 12/72, H01R 12/73, H01R 25/16, H01R 9/26, H05K 7/14

(54) **MODULARES BUSSYSTEM**
MODULAR BUS SYSTEM
SYSTÈME DE BUS MODULAIRE

(30) Priorität: 23.03.2015 DE 102015104290
(43) Veröffentlichungstag der Anmeldung: 31.01.2018
(73) Patentinhaber: Phoenix Contact GmbH & Co. KG, 32825 Blomberg (DE)
(72) Erfinder: MÜLLER, Frank, 32760 Detmold (DE); WERMTER, Peter, 32825 Blomberg (DE)
(74) Vertreter: Blumbach · Zinngrebe Patentanwälte PartG mbB
(86) Internationale Anmeldenummer: PCT/EP2016/056385
(87) Internationale Veröffentlichungsnummer: WO 2016/151019

(56) Entgegenhaltungen:
- WO-A1-99/23737
- DE-A1-102004 056 363
- DE-U1-202011 000 835
- US-A- 6 033 268
- US-A1- 2013 045 613

## Beschreibung

### Gebiet der Erfindung

Die Erfindung bezieht sich auf ein modulares Bussystem, bei dem einzelne Eingabe-/Ausgabe-Funktionsmodule in einer Richtung längs auf einer Tragschiene nebeneinander angereiht sind.

Die einzelnen Funktionseinheiten oder Module können unterschiedliche Baubreiten, Anzahl der Kanäle und Anzahl der Anschlusselemente aufweisen, woraus sich bei der Station dann für die Gesamtfunktionalität eine bestimmte Baubreite ergibt. In der Praxis ist eine gewisse Starre in dem Platzbedarf für die verschiedenen Einheiten oder Module anzutreffen. Wenn beispielsweise weniger Kanäle für die Gesamtfunktionalität benötigt werden, als mit den vorhandenen Einheiten oder Modulen zur Verfügung gestellt werden, wird Platz längs der Tragschiene verschwendet.

Aus der DE 20 2011 000 835 U1 ist ein Anschlusssystem zum Anschließen von busfähigen Anschluss- und/oder Funktionsmodulen bekannt. Das Anschlusssystem weist einen Anschlussblock mit mehreren Steckplätzen auf.

Die US 6, 033, 268 offenbart ein modulares Eingabe-/Ausgabe-System mit mehreren Reihen modularer Einheiten, die seriell mit einer Prozesssteuerung verbunden sind und wobei jede der modularen Einheiten mehrere Einsteckmodule aufweist. Die einzelnen modularen Einheiten können in eine Reihe von modularen Einheiten eingefügt oder aus ihnen entfernt werden, d.h. elektrisch verbunden oder getrennt werden, ohne benachbarte Einheiten zu stören.

### Allgemeine Beschreibung der Erfindung

Der Erfindung liegt die Aufgabe zugrunde, die Anordnung von Eingabe-/Ausgabe-Funktionsmodulen und deren Kommunikationsmöglichkeiten in einem modularen Bussystem flexibel zu gestalten.

Ein Kerngedanke der Erfindung kann darin gesehen werden, Eingabe-/Ausgabe-Funktionsmodule mit einer integrierten elektronischen Einrichtung zur Kommunikation mit dem modularen Bussystem auszustatten und nicht nur längs zur Tragschiene nebeneinander, sondern auch quer zur Schiene anzuordnen.

Das oben genannte technische Problem wird durch die Merkmale des Anspruchs 1 gelöst.

Danach ist ein modulares Bussystem mit folgenden Merkmalen vorgesehen:
- eine Tragschiene, die eine Grundfläche und eine Längsachse aufweist,
- wenigstens ein an der Tragschiene montierbares Basismodul zum elektrischen Verbinden mit wenigstens einem Eingabe-/Ausgabe-Funktionsmodul, das eine Rückwandleiterplatte aufweist, an der wenigstens eine Gruppe von wenigstens zwei ersten elektrischen Verbindern zur elektrischen Kopplung mit einem elektrischen Verbinder eines Eingabe-/Ausgabe-Funktionsmoduls angeschlossenen ist, wobei die wenigstens zwei ersten elektrischen Verbinder der wenigstens einen Gruppe bezüglich einer gedachten Linie, die senkrecht zur Längsrichtung der Tragschiene verläuft, hintereinander angeordnet sind und in einer Ebene liegen, in der die Grundfläche der Tragschiene liegt oder die parallel zur Grundfläche liegt,

- wenigstens ein Eingabe-/Ausgabe-Funktionsmodul, das einen elektrischen Verbinder und eine elektronische Einrichtung zur Kommunikation mit dem modularen Bussystem aufweist, wobei der elektrische Verbinder des Eingabe-/Ausgabe-Funktionsmodul zum elektrischen Verbinden mit einem der elektrischen Verbinder des wenigstens einen Basismoduls ausgebildet ist,
- eine an der Rückwandleiterplatte des wenigstens einen Basismoduls angeordnete elektronische Einrichtung, die zur Kommunikation mit der elektronischen Einrichtung des wenigstens einen Eingabe-/Ausgabe-Funktionsmoduls ausgebildet ist, wobei an wenigstens einer Seite der Rückwandleiterplatte des wenigstens einen Basismoduls, die senkrecht zur Längsachse der Tragschiene verläuft, der zweite elektrische Verbinder zur elektrischen Kopplung mit dem komplementären zweiten elektrischen Verbinder eines weiteren Basismoduls vorgesehen ist, wobei der komplementäre zweite elektrische Verbinder an einer Seite einer Rückwandleiterplatte des weiteren Basismoduls, die senkrecht zur Längsachse der Tragschiene verläuft, angeordnet ist,
dadurch gekennzeichnet, dass die elektronische Einrichtung des wenigstens einen Basismoduls mit den ersten elektrischen Verbindern und dem wenigstens einen zweiten elektrischen Verbinder elektrisch verbunden ist und eine Auswerte- und Steuereinrichtung aufweist, welche dazu ausgebildet ist, zu erkennen, ob ein Eingabe-/Ausgabe-Funktionsmodul an einem der ersten elektrischen Verbinder angeschlossen ist, und wenn ja, an welchem oder welchen ersten elektrischen Verbindern jeweils ein Eingabe-/Ausgabe-Funktionsmodul angeschlossen ist.

Angemerkt sei, dass die ersten und zweiten elektrischen Verbinder als Steckplätze ausgebildet sein können.

Vorteilhaft ist, dass die elektronische Einrichtung des wenigstens einen Basismoduls dazu ausgebildet ist, die ersten elektrischen Verbinder und den wenigstens einen zweiten elektrischen Verbinder gezielt miteinander zu verbinden, so dass an das wenigstens eine Basismodul angeschlossene Eingabe-/Ausgabe-Funktionsmodule miteinander und/oder mit der elektronischen Einrichtung und/oder mit Eingabe-/Ausgabe-Funktionsmodulen, welche an ein weiteres Basismoduls angeschlossen sind, kommunizieren können.

Zweckmäßig ist ferner, dass das wenigstens eine Basismodul einen Aufnahmekörper aufweist, der wenigstens eine Gruppe von wenigstens zwei Aufnahmebereiche aufweist, wobei jeder Aufnahmebereich sich senkrecht zur Grundfläche der Tragschiene erstreckt und dazu ausgebildet ist, ein Eingabe-/Ausgabe-Funktionsmodul wenigstens teilweise aufzunehmen, wobei die wenigstens zwei Aufnahmebereiche der wenigstens einen Gruppe bezüglich einer gedachten Linie, die senkrecht zur Längsrichtung der Tragschiene verläuft, hintereinander angeordnet sind und in einer Ebene liegen, in der die Grundfläche der Tragschiene liegt oder die parallel zur Grundfläche liegt, wobei jeder Aufnahmebereich einem der ersten elektrischen Verbinder zugeordnet ist.

Vorteilhaft ist, dass das wenigstens eine Basismodul eine an der Tragschiene montierbare Trägerplatte aufweist, die dazu ausgebildet ist, die Rückwandleiterplatte und den Aufnahmekörper zu tragen.

Eine vorteilhafte Weiterbildung sieht ein Kopfmodul vor, das elektrisch mit einem Kopf-Basismodul verbindbar ist, wobei das Kopf-Basismodul einen elektrischen Verbinder zum elektrischen Verbinden mit dem wenigstens einen Basismodul aufweist.

Eine vorteilhafte Weiterbildung sieht vor, dass das Kopfmodul zur Kommunikation mit den an dem wenigstens einen Basismodul angeschlossenen Eingabe-/Ausgabe-Funktionsmodulen ausgebildet ist.

Nach einer vorteilhaften Ausgestaltung der Erfindung werden mehrere Basismodule nebeneinander auf der Tragschiene angeordnet, wobei die vertikalen Steckplätze ein Rasterfeld bilden. Das Rasterfeld umfasst mindestens zwei Reihen von Steckplätzen, die übereinander angeordnet sind. So können mehr unterschiedliche Eingabe/Ausgabe-Funktionsmodule auf einer bestimmten Baubreite zur Erzielung einer Station miteinander kombiniert werden. Die Baubreite der einzelnen Eingabe-/Ausgabe-Funktionsmodule braucht nicht einheitlich zu sein, vielmehr kann auch das Zwei- oder Mehrfache des Rasters für die Baubreite gewählt werden, d. h. ein Eingabe/Ausgabe-Funktionsmodul kann zwei oder mehr Rastereinheiten einnehmen.

Das modulare Bussystem kann ein Kopfmodul umfassen, das über einen horizontalen Steckplatz mit dem wenigstens einen Basismodul verbunden ist. Die Abmessung des Kopfmoduls in Schienenlängsrichtung bewegt sich in dem vorgegebenen Raster, kann aber die Breite eines Basismoduls unterschreiten oder überschreiten.

Das modulare Bussystem umfasst zweckmäßig einen Buskoppler, der über ein Kopf-Basismodul mit dem Kopfmodul verbunden ist. Dieses Kopf-Basismodul folgt dem Raster des Systems und nimmt gewöhnlich eine größere Breite ein, als das gewöhnliche Basismodul.

Es ist auch möglich, dass das Kopfmodul und der Buskoppler in fester Kombination ein Basisblockmodul bilden, das eine gemeinsame Rückwandleiterplatte aufweist, die mit einem horizontalen Steckplatz und mit mehreren vertikalen Steckplätzen zum Anschließen des Kopfmoduls und einer Gruppe von Eingabe/Ausgabe-Funktionsmodulen versehen ist. Ein solches Basisblockmodul kann für sich eine Busstation bilden, es ist aber auch möglich, weitere Basismodule über den horizontalen Steckplatz anzuschließen und die weiteren Basismodule mit weiteren Eingabe/Ausgabe-Funktionsmodulen zu bestücken, womit größere Busstationen mit mehr Funktionalitäten aufgebaut werden können.

Ausführungsbeispiele der Erfindung werden anhand der Zeichnungen beschrieben. Dabei zeigt:
- Fig. 1: ein beispielhaftes modulares Bussystem mit drei Basismodulen, die getrennt nebeneinander auf einer Tragschiene montiert sind,
- Fig. 2: ein Eingabe-/Ausgabe-Funktionsmodul,
- Fig. 3: ein weiteres Eingabe-/Ausgabe-Funktionsmodul,
- Fig. 4: ein weiteres Eingabe-/Ausgabe-Funktionsmodul,
- Fig. 5: ein weiteres Eingabe-/Ausgabe-Funktionsmodul,
- Fig. 6: ein weiteres Eingabe-/Ausgabe-Funktionsmodul,
- Fig. 7: ein weiteres Eingabe-/Ausgabe-Funktionsmodul,
- Fig. 8: das in Fig. 1 gezeigte modulare Bussystem mit zusammengefügten Basismodulen und diversen Eingabe-/Ausgabe-Funktionsmodule vor dem Einsetzen in die Basismodule,
- Fig. 9: das in Fig. 1 und 8 gezeigte modulare Bussystem mit in den Basismodulen eingesetzten Eingabe-/Ausgabe-Funktionsmodulen und mit einer ein Kopfmodul aufweisenden Eingabe-/Ausgabe-Bus-Station,
- Fig. 10: das in Fig. 9 gezeigte modulare Bussystem mit entkoppelten Basismodulen, exponierten Rückwandleiterplatten der Basismodule und zwei Leiterplatten des in Fig. 2 gezeigten Eingabe-/Ausgabe-Funktionsmodul,
- Fig. 11: ein Basisblockmodul mit integriertem Buskoppler,
- Fig. 12: eine exponierte Rückwandleiterplatte des in Fig. 11 gezeigten Basisblockmoduls,
- Fig. 13: ein weiteres beispielhaftes modulares Bussystem mit dem in Fig. 11 gezeigten Basisblockmodul neben einem in Fig. 1 gezeigten Basismodul,
- Fig. 14: das in Fig. 13 gezeigte modulare Bussystem, bei dem das Basisblockmodul und das mit Eingabe-Ausgabe/-Funktionsmodulen bestückte Basismodul gekoppelt sind.

### Detaillierte Beschreibung der Erfindung

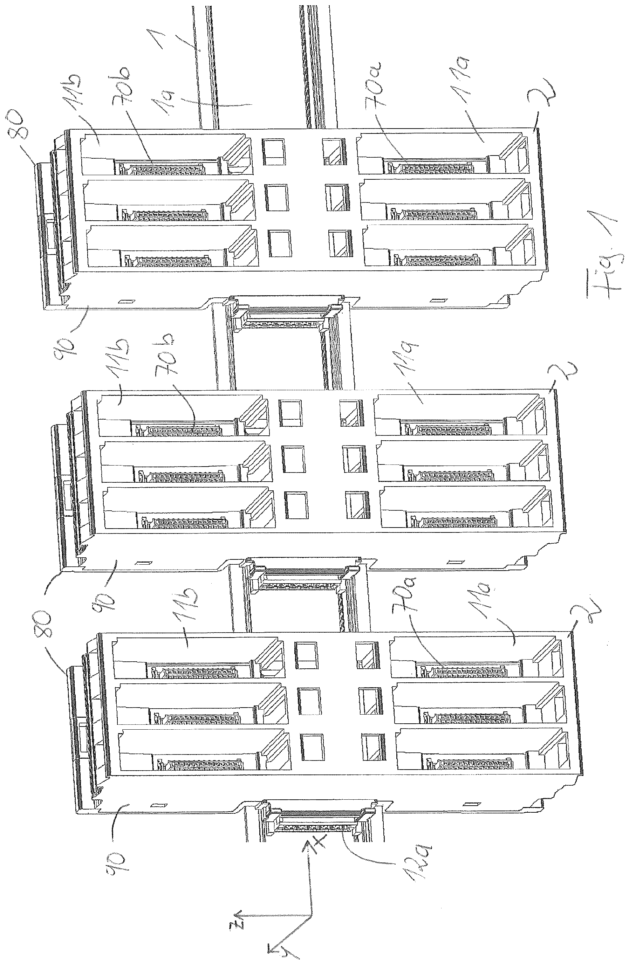

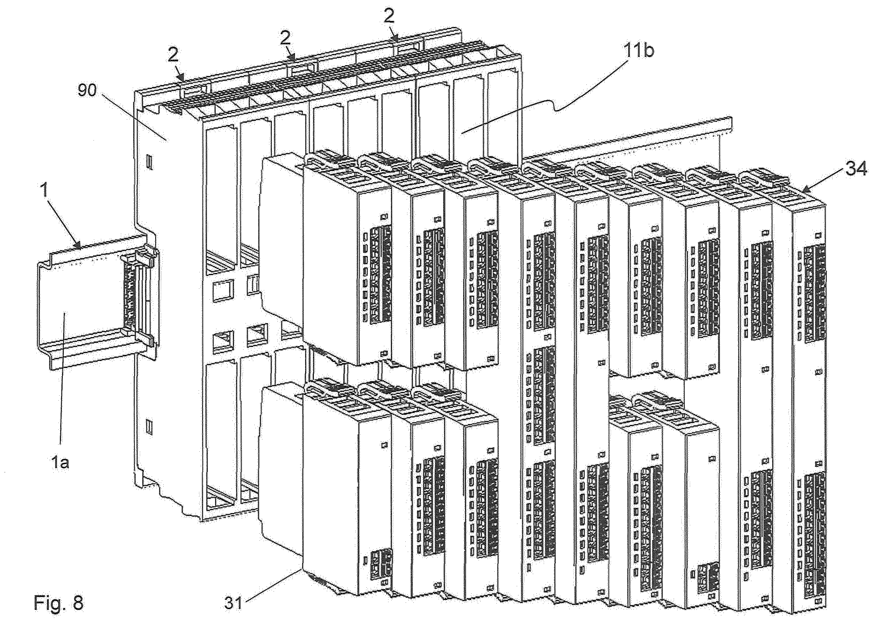

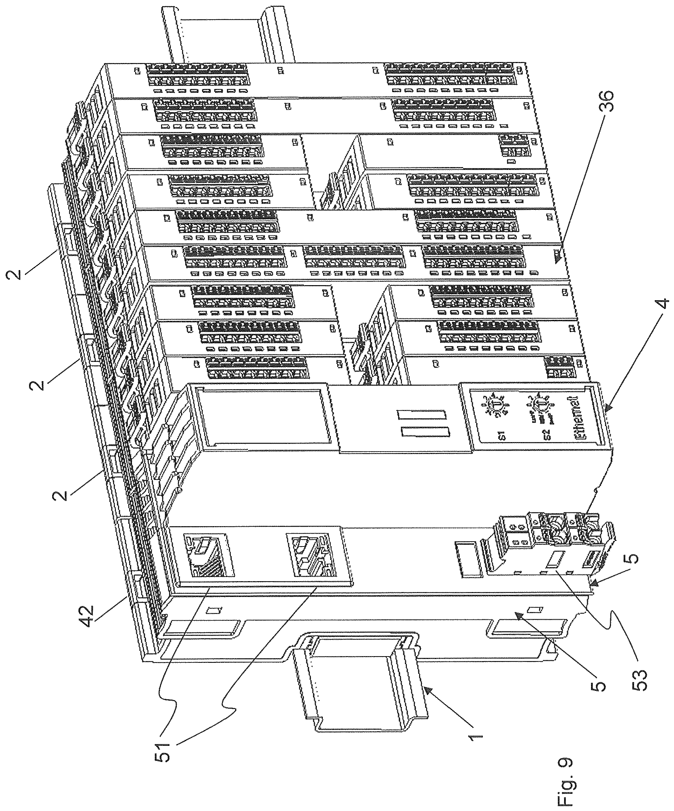

Fig. 1 zeigt ausschnittsweise ein beispielhaftes modulares Bussystem 100 mit drei entkoppelten Basismodulen 2, die mit gegenseitigem Abstand an einer Tragschiene 1 montiert, vorzugsweise auf der Tragschiene 1 aufgesteckt sind.
Bereits an dieser Stelle sei angemerkt, dass die Basismodule 2 für einen ordnungsgemäßen Betrieb elektrisch und gegebenenfalls mechanisch miteinander verbunden werden, wie dies zum Beispiel in Fig. 8 oder 9 gezeigt ist.

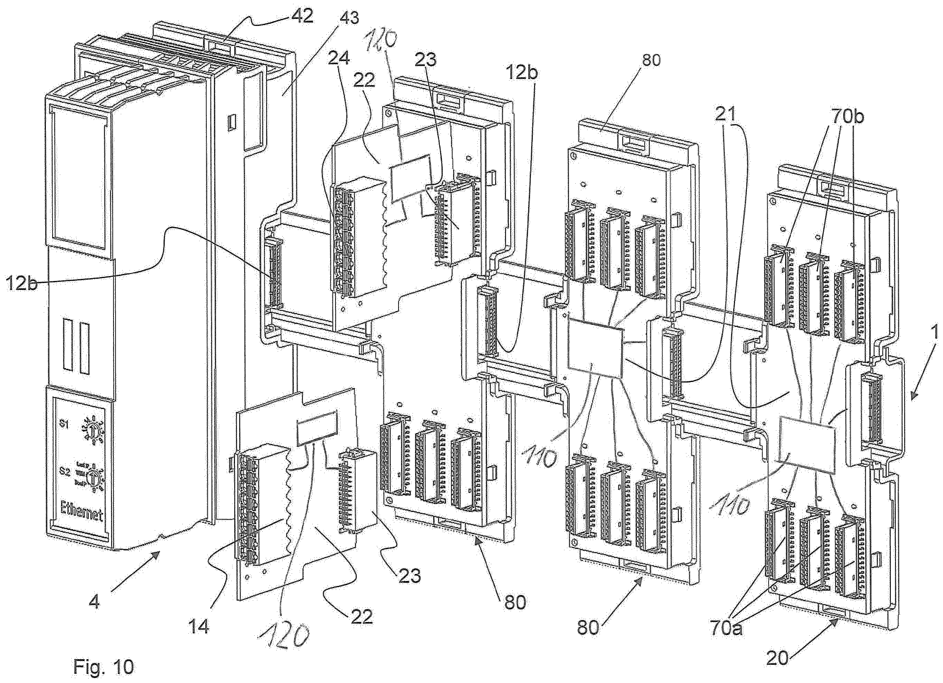

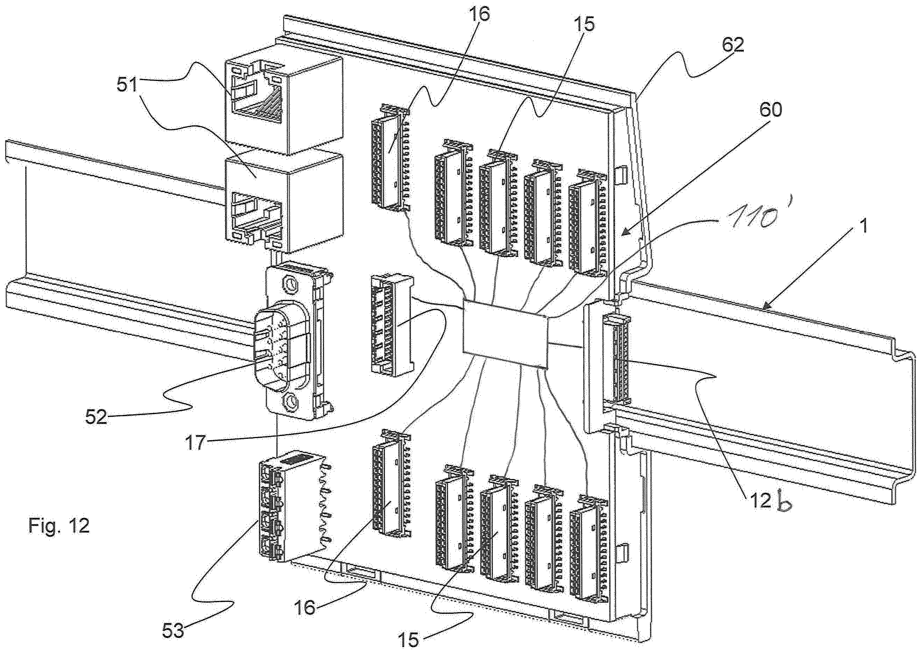

Die geometrische Ausrichtung der Basismodule 2 und deren Komponenten bezüglich der Tragschiene 1 lässt sich am einfachsten unter Zuhilfenahme eines 3D-Koordinatensystems mit den Achsen x, y und z erläutern, wobei in Fig. 1 die Längsachse der Tragschiene 1 mit der x-Achse zusammenfällt. Die Tragschiene 1 weist eine Grundfläche 1a auf, die sich bei der in Fig. 1 gewählten Ansicht in x-Richtung erstreckt und in einer durch die X- und z-Achse aufgespannten Ebene liegt. Angemerkt sei an dieser Stelle, dass in den Fig. 8, 9, 11, 13 und 14 die Tragschiene 1 in derselben Ebene angeordnet isst. Lediglich in den Fig. 10 und 12 verläuft die Längsachse der Tragschiene 1 parallel zur y-Achse und die Grundfläche 1a der Tragschien liegt in einer Ebene die, durch die y- und z- Achse aufgespannt wird.

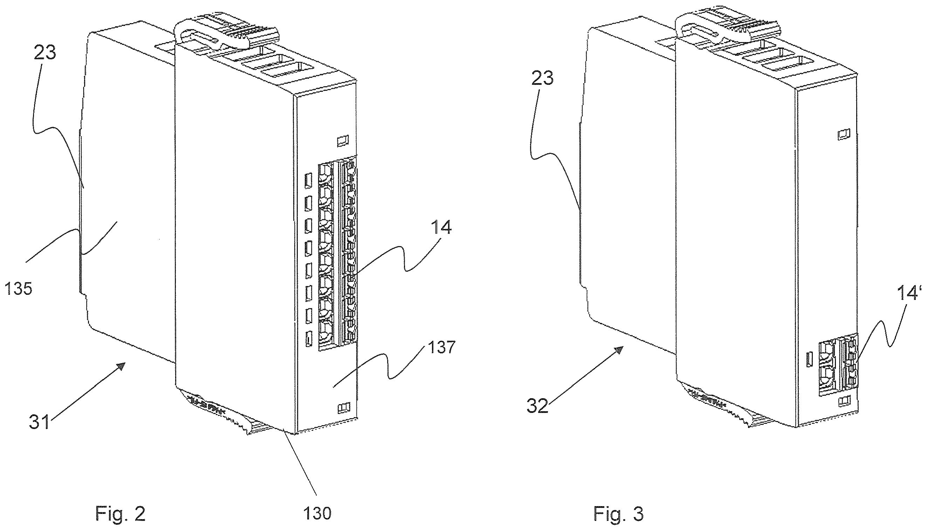

Nunmehr werden Fig. 1 und Fig. 10 zusammen betrachtet In Fig. 10 das in Fig. 1 gezeigte modulare Bussystem 100 mit einem Kopfmodul 4 und entfernten Aufnahmekörpern 90 dargestellt, wodurch die Rückwandleiterplatten 21 exponiert dargestellt sind. Das Kopfmodul 4 kann mit einer Rückwandleiterplatte 43 elektrisch verbunden sein, die wiederum an einer Trägerplatte 42 zur Montage an der Tragschiene 1 befestigt sein kann. An der Rückwandleiterplatte 42 ist ein elektrischer Verbinder 12 zum elektrischen Koppeln mit einem Basismodul 2 angeordnet. Ferner ist der innere Aufbau des zum Beispiel des in Fig. 2 gezeigten Eingabe-/Ausgabe-Funktionsmoduls 31 gezeigt.

Jedes Basismodul 2 weist, wie in Fig. 10 zu sehen ist, eine Rückwandleiterplatte 21 auf, deren Hauptebene bzw. Grundfläche gewöhnlich gemäß einer senkrechten Ebene angeordnet ist, wenn die Tragschiene 1 in einem Schaltschrank montiert ist. Mit anderen Worten: Die Grundfläche der Rückwandleiterplatten 21 der in Fig. 1 gezeigten Basismodule liegt in der x-z-Ebene, während die Grundflächen der in Fig. 10 gezeigten Rückwandleiterplatten 21 in der y-z-Ebene liegen. Wie Fig. 1 zeigt, weist jedes Basismodul 2 ferner eine Vielzahl von Aufnahmebereichen 11a und 11b, beispielsweise in Form von fachartigen oder buchsenartigen Steckplätzen auf, in die jeweils ein Eingabe-/Ausgabe-Funktionsmodul in y-Richtung bzw. senkrecht zur Grundfläche 1a der Tragschiene und somit senkrecht zu einer Rückwandleiterplatte 21 eingesetzt werden kann. Ein solches Eingabe-/Ausgabe-Funktionsmodul ist beispielsweise in Fig. 2 gezeigt und mit Bezugszeichen 31 gekennzeichnet. Beispielsweise weist jedes Basismodul 2 sechs Aufnahmebereiche bzw. Steckplätze 11a und 11b auf, wobei beispielsweise die drei Steckplätze 11a und die drei Steckplätze 11b symmetrisch zur x-Achse bzw. zur Längsachse der Tragschiene 1 angeordnet sein können. Mit anderen Worten: Jeweils zwei Aufnahmebereiche 11a und 11b bilden eine Gruppe von Aufnahmebereichen, die auf einer gedachten Linie liegen, die parallel zur z-Achse verläuft. Die jeweils zu einer Gruppe gehörenden Aufnahmebereiche 11a und 11b sind somit senkrecht zur Längsachse der Tragschiene 1 angeordnet und liegen in derselben Ebene wie die Grundfläche 1a der Tragschiene 1. Jede Gruppe von Aufnahmebereichen 11a und 11b kann auch mehr als zwei Aufnahmebereiche 11a und 11b, die auf einer Linie parallel zur z-Achse liegen, aufweisen. Die in Fig. 1 beispielhaft gezeigten Basismodule 2 weisen somit jeweils drei Gruppen mit jeweils zwei Aufnahmebereichen 11a und 11b auf, wobei die Gruppen bezüglich der x-Achse bzw. der Längsachse der Tragschiene 1 hintereinander angeordnet sind.

Die in Fig. 1 beispielhaft gezeigten Aufnahmebereiche 11a und 11b können jeweils einen rechteckförmigen Querschnitt aufweisen, wobei die Längsachsen der Aufnahmebereiche einer Gruppe jeweils auf einer Linie liegen, die parallel zur z-Achse verläuft. Jeder Aufnahmebereich 11a und 11b weist eine vorbestimmte Höhe auf, die sich in -y-Richtung erstreckt. Die sechs Aufnahmebereiche 11a und 11b können beispielsweise in einem einstückigen Aufnahmekörper 90 integriert sein, der zum Beispiel ein Kunststoffteil ist. Angemerkt sei, dass jeder Aufnahmekörper 90 zumindest eine Gruppe von zumindest zwei Aufnahmebereichen 11a und 11b aufweist. Der Aufnahmekörper 90 dient vornehmlich dazu, Eingabe-/Ausgabe-Funktionsmodule 31 beim Einsetzen zu führen und anschließend zu halten.

Wie beispielsweise in Fig. 1 und 10 zu sehen ist, weist jedes Basismodul 2 ferner eine Trägerplatte 80 auf, an der die jeweilige Rückwandleiterplatte 21 vorzugsweise lösbar montiert ist. Jedes Basismodul 2 kann mittels einer solchen Trägerplatte 80 an der Tragschiene 1 befestigt werden. Hierzu weist jede Trägerplatte 80 entsprechende Halte- und/oder Rastmittel auf.

Im montierten Zustand ist jeder Aufnahmekörper 90 auf einer Trägerplatte 80 aufgesetzt, so dass jede Rückwandleiterplatte 21 bodenseitig von der Trägerplatte 80 und seitlich von dem Aufnahmeteil 90 umgeben ist. Dies ist am besten In Fig. 1 in Verbindung mit Fig. 10 zu sehen.

Wie aus Fig. 10 ferner ersichtlich ist, sind an jeder Rückwandleiterplatte 21 mehrere erste elektrische Verbinder 70a und 70b angeordnet, die mit einer an der Rückwandleiterplatte 21 montierten elektronischen Einrichtung 110 elektrisch verbunden sind. Jedes Basismodul 2 weist somit eine integrierte elektronische Einrichtung auf. Die ersten elektrischen Verbinder 70a und 70b können die Form von elektrischen Anschlussleisten oder elektrischen Steckplätze aufweisen, die bei aufgesetztem Aufnahmekörper 90 fluchtend zu den Aufnahmebereichen 11a und 11b angeordnet sind. Mit anderen Worten: Jeweils zwei erste elektrische Verbinder 70a und 70b bilden eine Gruppe und liegen auf einer gedachten Linie, die parallel zur z-Achse verläuft. Sie verlaufen somit senkrecht zur Längsachse der Tragschiene 1 und liegen in derselben Ebene wie die Grundfläche 1a der Tragschiene 1 oder in einer Ebene, die parallel zur Grundfläche 1a liegt. Jede Gruppe kann auch mehr als zwei erste elektrische Verbinder 70a und 70b aufweisen.

Die in Fig. 10 beispielhaft gezeigten Basismodule 2 weisen somit jeweils drei Gruppen mit jeweils zwei ersten elektrischen Verbinder 70a und 70 auf, wobei die Gruppen bezüglich der y-Achse bzw. der Längsachse der Tragschiene 1 hintereinander angeordnet sind. Die in Fig. 10 gezeigten elektrischen Verbinder 70a und 70b weisen jeweils einen rechteckförmigen Querschnitt auf, wobei die Längsachse jedes elektrischen Verbinders parallel zur z-Achse verläuft. Die elektrischen Verbinder 70a und 70b einer Gruppe liegen somit auf einer Linie, die parallel zur z-Achse liegt.

Jedes Eingabe-/Ausgabe-Funktionsmodul, welches beispielhaft in den Fig. 2-4 gezeigt ist, weist, wie in Fig. 10 zu sehen ist, eine als Funktionsleiterplatte bezeichnete Leiterplatte 22 auf, an der eine elektronische Einrichtung 120 und ein elektrischer Verbinder 23, der komplementär zu den elektrischen Verbindern 70a und 70b der Rückwandleiterplatten 21 ausgebildet ist, montiert sind. Der elektrische Verbinder 23 jedes Eingabe-/Ausgabe-Funktionsmodul ist derart an der, im montierten Zustand zur Grundfläche 1a der Tragschiene 1 weisenden Unterseite der Funktionsleiterplatte 22 angeordnet, dass er beim Einsetzen des Eingabe-/Ausgabe-Funktionsmodul in ein Basismodul 2 mit einem der ersten elektrischen Verbinder 70a oder 70b gepaart werden kann. Weiterhin kann an der Funktionsleiterplatte 22 jedes Eingabe-/Ausgabe-Funktionsmodul ein weiterer elektrischer Verbinder 14 angeordnet sein, an den ein externes Geräts, beispielsweise ein Sensor oder ein Aktor (nicht dargestellt) angeschlossen werden kann. Der weitere elektrische Verbinder 14 ist an einer Seite der Funktionsleiterplatte 22 angeordnet, die der Seite, an der der elektrische Verbinder 23 angeordnet ist, gegenüberliegt. Die elektrischen Verbinder 23 und 14 können einen rechteckförmigen Querschnitt aufweisen, dessen Längsachse jeweils in z-Richtung weist, wenn das jeweilige Eingabe-/Ausgabe-Funktionsmodul im montierten Zustand in einem Aufnahmebereich 11a oder 11 sitzt.

Das in Fig. 2 gezeigte Eingabe-/Ausgabe-Funktionsmodul 31 kann in y-Richtung in einen der Aufnahmebereiche 11a oder 11b eingeführt werden, wobei im eingeführten Zustand der elektrische Verbinder 23 des Eingabe-/Ausgabe-Funktionsmoduls 31 elektrisch mit einem der ersten elektrischen Verbinder 70a oder 70b gepaart, d.h. verbunden ist. Dieser Zustand ist zum Beispiel in Fig. 10 gezeigt.

Fig. 9 zeigt zum Beispiel ein Eingabe-/Ausgabe-Funktionsmodul 31 im eingesetzten Zustand.

Bezogen auf die in Fig. 10 gezeigte Ausrichtung der Tragschiene 1 wird ein Eingabe-/Ausgabe-Funktionsmodul, zum Beispiel das in Fig. 2 gezeigte Eingabe-/Ausgabe-Funktionsmodul 31, in x-Richtung in einen entsprechenden Aufnahmebereich 11a oder 11b eingesetzt, während es bei der in Fig. 1 oder Fig. 9 gezeigten Ausrichtung der Tragschiene 1 in y-Richtung in einen entsprechenden Aufnahmebereich 11a oder 11b eingesetzt wird.

Die elektronische Einrichtung 110 jeder in Fig. 10 gezeigten Rückwandleiterplatte 21 weist eine Auswerte- und Steuereinrichtung auf, die dazu ausgebildet ist, zu erkennen, ob ein elektrischer Verbinder 70a und/oder 70b mit einem Eingabe-/Ausgabe-Funktionsmodul elektrisch verbunden ist, und wenn ja, welcher oder welche elektrischen Verbinder 70a und/oder 70b jeweils mit einem Eingabe-/Ausgabe-Funktionsmodul elektrisch verbunden sind. Dies ist möglich, da die elektrischen Verbinder 70a und 70b in einer festgelegten Reihenfolge an die elektronische Einrichtung 110 angeschlossen sind.

Jede Rückwandleiterplatte 21 weist wenigstens einen zweiten elektrischen Verbinder 12a und/oder 12b auf, der an einer Längsseite der Rückwandleiterplatte 21 angeordnet ist, wobei die Längsseite parallel zur z-Achse des in Fig. 1 gezeigten Koordinatensystems verläuft, wenn das jeweilige Basismodul 2 an der Tragschiene 1 befestigt ist. Vorzugsweise weist jede Rückwandleiterplatte 21 zwei zweite elektrische Verbinder 12a und 12b auf, die jeweils an einer ihrer Längsseiten angeordnet sind. Die beiden zweiten elektrischen Verbinder 12a und 12b einer jeweiligen Rückwandleiterplatte 21 sind komplementär, zum Beispiel als Steckverbinder bzw. als Buchsenverbinder ausgebildet, und fluchten, sobald mehrere Basismodule 2 an der Tragschiene 1 montiert sind, zu den zweiten elektrischen Verbindern 12a bzw. 12b benachbarter Basismodule 2. Die zweiten elektrischen Verbinder 12 dienen somit zur elektrischen Kopplung der Basismodule 2. In der Praxis werden die Basismodule 2 auf der Tragschiene 1 gegeneinander verschoben, bis sie eng aneinander gerückt sind und eine elektrische Verbindung untereinander sicher hergestellt ist, wie dies zum Beispiel in Fig. 9 gezeigt ist.

Wenn die Basismodule 2 eng miteinander benachbart sind, bilden die zum Beispiel in Fig. 1 gezeigten fachartigen oder buchsenartigen Aufnahmebereiche 11a und 11b vertikale Steckplätze in Form eines Rasterfeldes mit zwei Reihen von Rastereinheiten. Das Rasterfeld kann mit Eingabe/Ausgabe-Funktionsmodulen in passender und beliebiger Anordnung bestückt werden.

Die in Fig. 10 gezeigte elektronische Einrichtung 110 jeder Rückwandleiterplatte 21 kann ein Koppelfeld, das in der elektronischen Einrichtung 110 integriert sein kann, derart ansteuern, dass die ersten elektrischen Verbinder 70a und 70b und die zweiten elektrischen Verbinder 12a und 12b gezielt miteinander verbunden werden können. Auf diese Weise können Eingabe-/Ausgabe-Funktionsmodule, die mit den ersten elektrischen Verbindern 70a und/oder 70b eines Basismoduls 2 verbunden sind, in gezielter Weise miteinander und/oder über die zweiten elektrischen Verbinder 12 mit Eingabe-/Ausgabe-Funktionsmodulen benachbarter Basismodule 2 kommunizieren. Diese Kommunikation wird durch die elektronischen Einrichtungen 110 der jeweiligen Basismodule 2 bzw. der jeweils dazugehörenden Rückwandleiterplatten 21 und den elektronischen Einrichtungen 120, die in den jeweiligen Eingabe-/Ausgabefunktionsmodul integriert sind, gesteuert. Alternativ kann jede Rückwandleiterplatte 21 ein Koppelfeld aufweisen, dass die ersten elektrischen Verbinder 70a und 70b und die zweiten elektrischen Verbinder 12a und 12b fest miteinander verbindet. Auf diese Weise können die Eingabe-/Ausgabe-Funktionsmodule und auch die Basismodule 2 mit einem Kopfmodul 5 kommunizieren, welches hierzu eine geeignet ausgebildete elektronische Einrichtung aufweist. Das Kopfmodul 5 ist unter anderem in Fig. 9 gezeigt.

Die elektronische Einrichtung 120 jedes Eingabe-/Ausgabe Funktionsmoduls kann einen Speicher (nicht gezeigt) aufweisen, in dem zum Beispiel Informationen über die Funktion, den Hersteller oder andere modulspezifische Kennungen des jeweiligen Eingabe-/Ausgabe-Funktionsmodul gespeichert sind. Funktionsinformationen enthalten zum Beispiel Angaben über ein Eingabe-/Ausgabe-Funktionsmodul, das einen analogen Eingang, einen digitalen Eingang, einen digitalen Ausgang und/oder einen analogen Ausgang aufweist. Die elektronische Einrichtung 120 jedes Eingabe-/Ausgabe-Funktionsmoduls kann dazu ausgebildet sein, zu erkennen, ob das Eingabe-/Ausgabe-Funktionsmodul mit einem Basismodul 2 elektrisch verbunden ist. Ferner kann jedes Eingabe-/Ausgabe-Funktionsmodul dazu ausgebildet sein, mit oder ohne Aufforderung der elektronischen Einrichtung 110 des Basismoduls 2, mit dem das Eingabe-/Ausgabe-Funktionsmodul verbunden ist, die gespeicherte Informationen zur elektronischen Einrichtung 110 des Basismoduls 2 zu übertragen. Demzufolge kann die elektronische Einrichtung 110 jedes Basismoduls 2 bzw. jeder Rückwandleiterplatte 21 dazu ausgebildet sein, nach dem Erkennen eines eingesetzten Eingabe-/Ausgabe-Funktionsmodul die elektronische Einrichtung 120 des erkannten Eingabe-/Ausgabe-Funktionsmodul aufzufordern, die gespeicherten Informationen zu ihm zu übertragen.

Die Fig. 2 bis 7 stellen Eingabe-/Ausgabe-Funktionsmodule 31 bis 36 in diversen Ausführungsformen dar.

Fig. 2 zeigt das Eingabe-/Ausgabe-Funktionsmodul 31 mit einem Gehäuse 130, in dem die in Fig. 10 gezeigte bestückte Funktionsleiterplatte 22 angeordnet ist. Ebenfalls zu sehen ist der in Fig. 10 dargestellte elektrische Verbinder 14, auch als vorderseitiger vertikaler Steckplatz bezeichnet, an den ein externes Gerät wie zum Beispiel ein Sensor oder Aktor angeschlossen werden kann. Ferner ist der in Fig. 10 dargestellte, zur Grundfläche 1a der Tragschiene 1 weisende elektrische Verbinder 23 in Fig. 2 angedeutet. Der elektrische Verbinder 23 kann auch als rückseitiger vertikaler Steckplatz bezeichnet werden, da er in y-Richtung und somit in vertikaler Richtung bezüglich der Grundfläche 1a der Tragschiene 1 in einen Aufnahmebereich 11a oder 11b eingeführt wird. Das Gehäuse 130 weist einen Gehäuseabschnitt 135 auf, dessen Querschnitt im Wesentlichen dem Querschnitt der in Fig. 1 gezeigten Aufnahmebereiche 11a und 11b entspricht, so dass der Gehäuseabschnitt 135 in einen der Aufnahmebereiche 11a oder 11b eingesetzt werden kann. Das Gehäuse 130 kann einen zweiten Gehäuseabschnitt 137 aufweisen, dessen Querschnitt größer als der Querschnitt des Gehäuseteils 135 ist. Die Abmessungen der Gehäuseteile 135 und 137 sind in y-Richtung des in Fig. 1 gezeigten Koordinatensystems so bemessen, dass im eingesetzten Zustand der überstehende Rand des Gehäuseabschnitts 137 auf dem äußeren Rand des entsprechenden Aufnahmebereichs 11a oder 11b zur Auflage kommt und der jeweilige erste elektrische Verbinder 70a oder 70b einer Rückwandleiterplatte 21 mit dem elektrischen Verbinder 23 der Funktionsleiterplatte 22 des Eingabe-/Ausgabe-Funktionsmoduls 31 elektrisch miteinander gekoppelt ist. In Fig. 10 ist zu sehen, dass die äußere Umrandung der Funktionsleiterplatte 22 mit der Form des Gehäuses 130 übereinstimmt.

Die Ausführungsformen der Eingabe-/Ausgabe-Funktionsmodule 31, 32 und 33 passen zu jeweils einem der vertikalen Steckplätze 11a oder 11b des Basismoduls 2 und können deshalb sowohl in die obere als auch in die untere Reihe der vertikalen Steckplätze 11a bzw. 11b der Basismodule 2 eingesteckt werden. Die Ausführungsformen der in Fig. 2 bis 4 gezeigten Eingabe-/Ausgabe-Funktionsmodule 31 bis 34 unterscheiden sich nur in der Anzahl an Kontakten bzw. der Größe der jeweiligen elektrischen Verbinder 14, 14' und 14".

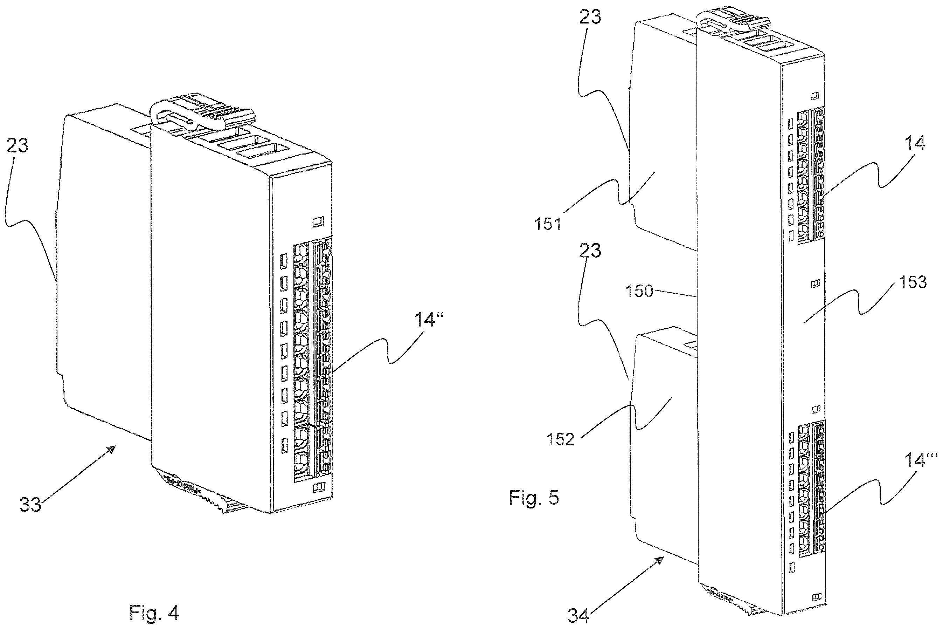

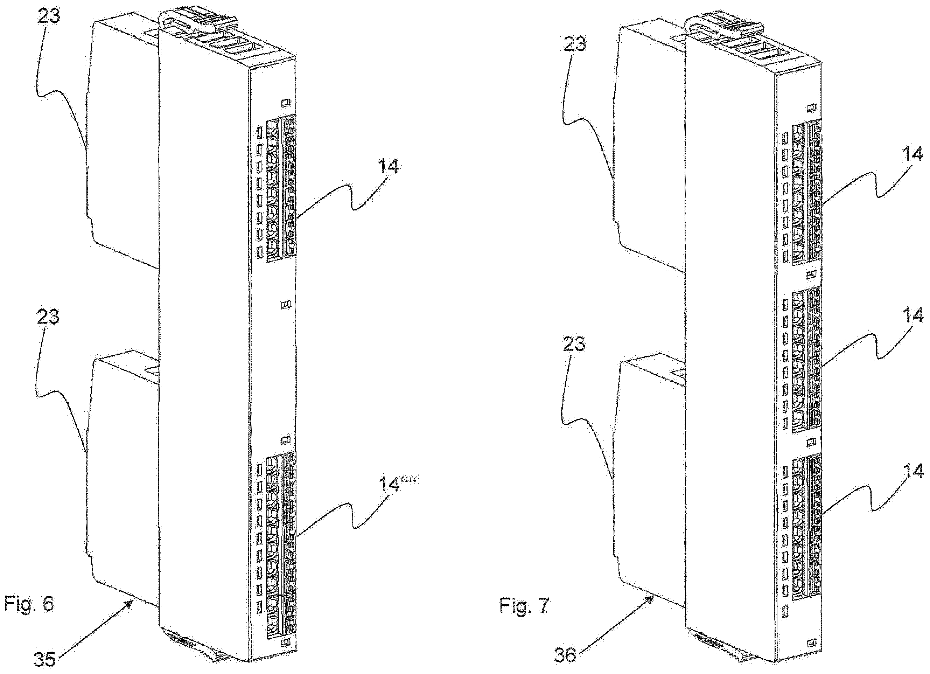

Die in den Fig. 5 und 6 gezeigten Eingabe-/Ausgabe-Funktionsmodule 34 und 35 weisen jeweils ein Gehäuse 150 auf, in dem jeweils zwei Eingabe-/Ausgabe-Funktionsmodule angeordnet sind. Sie unterscheiden sich nur in der Größe der elektrischen Verbinder 14'" bzw. 14"". In dem Gehäuse 150 sind zwei separate Funktionsleiterplatten aufgenommen, die in Funktion und Aufbau jeweils der in Fig. 10 gezeigten bestückten Funktionsleiterplatte 22 entsprechen können. Das Gehäuse 150 weist zwei sich in y-Richtung erstreckende Gehäuseabschnitte 151 und 152 auf, die jeweils einen Querschnitt haben, der etwas kleiner als der Querschnitt der in Fig. 1 gezeigten Aufnahmebereiche 11a und 11b ist. Das Gehäuse 150 weist ferner einen in z-Richtung verlaufenden Gehäuseabschnitt 153 auf, an den sich die beiden Gehäuseabschnitte 151 und 152 anschließen. Die beiden Gehäuseabschnitte 151 und 152 sind in z-Richtung in einem Anstand zueinander angeordnet, der dem Abstand von zwei benachbarten Aufnahmebereichen 11a und 11b in z-Richtung entspricht. Elektrische Verbinder 14, 14'", 14"" und 23 sind entsprechend angedeutet. Das Gehäuse 150 bzw. die beiden darin angeordneten Eingabe-/Ausgabe-Funktionsmodule können somit in eine in Fig. 1 gezeigt Gruppe von Aufnahmebereichen 11a und 11b eingesetzt werden. Das in Fig. 7 gezeigte Eingabe-/Ausgabe-Funktionsmodul 36 unterscheidet sich von den in Fig. 5 und 6 gezeigten Ausführungsformen lediglich dadurch, dass ein dritter elektrischer Verbinder 14 vorgesehen ist.

In Fig. 8 ist das in Fig. 1 gezeigte modulare Bussystem 100 gezeigt, wobei die drei Basismodule 2 zu einem Block zusammengestellt und elektrisch gekoppelt sind, an den Eingabe-/Ausgabe-Funktionsmodule 31 bis 35 der diversen Ausführungsformen kurz vor der Ankopplung stehen. Ebenfalls dargestellt sind die Aufnahmekörper 90 der drei Basismodule 2.

In Fig. 9 ist das beispielhafte Bussystem 100mit drei gekoppelten Basismodulen 2 dargestellt, wobei die Aufnahmekörper 90 entfernt worden sind. Eingabe-/Ausgabe-Funktionsmodule 31 bis 35 sind mit den Basismodulen 2 gekoppelt. Zusätzlich sind ein Kopfmodul 4 und ein Buskoppler 5 dargestellt, die jeweils mit einem geeigneten Basismodul bzw. einer entsprechenden Rückwandleiterplatte elektrisch verbunden sind. Das Kopfmodul 4 ist an das Kopf-Basismodul 42 angeschlossen, das drei weitere Stecker oder Steckplätze nach Art der in Fig. 12 dargestellten Stecker bzw. elektrischen Verbinder 16, 17 enthält. Das Kopfmodul 4 selbst ist mit entsprechenden Gegenstecker (nicht dargestellt) versehen, die den rückseitigen vertikalen Steckplätzen 23 der Eingabe-Ausgabe-Funktionsmodule entsprechen. Der Buskoppler 5 enthält ferner Netzwerkanschlüsse 51 zum Anschluss eines anderen Bussystems oder eines anderen Netzwerkes, sowie einen sonstigen Anschluss 53.

Es wird darauf hingewiesen, dass die Einzelteile aus Darstellungsgründen mit Abstand voneinander gezeichnet sind, während fertig montiert die Basismodule 2 und das Kopfmodul 4 aneinander gerückt sind und eine Funktionseinheit bilden.

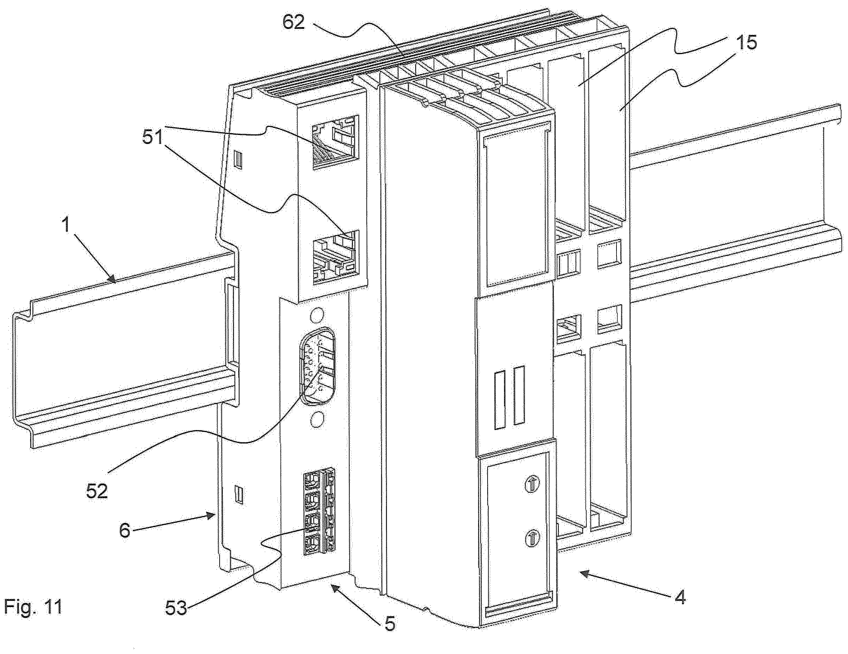

In Fig. 11 ist ein an der Tragschiene 1 montiertes Basisblockmodul 6 dargestellt, das eine feste Kombination der Funktionseinheiten des Kopfmoduls 4, des Buskopplers 5 und eines Überbrückungs-Basismoduls 62 mit Aufnahmebereichen 15 beinhaltet. Der Buskoppler 5 weist neben den Netzwerkanschlüssen 51 auch noch einen Computeranschluss 52 und einen sonstigen Anschluss 53 auf.

In Fig. 12 ist die exponierte Rückwandleiterplatte 60 des in Fig. 11 gezeigten Basisblockmoduls 6 zu sehen, auf der alle Anschlüsse bzw. elektrischen Verbinder 51, 52, 53, 12 und 15 sowie 16 und 17 positioniert sind, die für ein modulares Bussystem mit Eingabe-/Ausgabe-Funktionsmodulen zweckmäßig oder erforderlich sind. Weiterhin ist an der Rückwandleiterplatte 60 eine elektronische Einrichtung 110' vorgesehen, die einen Mikrocontroller oder Mikroprozessor und auch eine Speichereinrichtung aufweisen kann. Vorzugsweise kann sie all die Funktionen der elektronischen Einrichtung 110' ausführen. Die elektronische Einrichtung 110' ist dazu ausgebildet, zu erkennen, ob wenigstens einer der elektrischen Verbinder 15 und/oder 16 und/oder 17 mit einem Eingabe-/Ausgabe-Funktionsmodul elektrisch verbunden ist, und wenn ja, welcher oder welche elektrischen Verbinder jeweils mit einem Eingabe-/Ausgabe-Funktionsmodul elektrisch verbunden sind. Dies ist möglich, da die elektrischen Verbinder 15, 16 und 17 in einer festgelegten Reihenfolge an die elektronische Einrichtung 110' angeschlossen sind. Angemerkt sei, dass auch die elektrischen Verbinder 51-53 und 12 mit der elektronischen Einrichtung 110' verbunden sein können.

Die elektronische Einrichtung 110' kann ein Koppelfeld (nicht dargestellt), das in der elektronischen Einrichtung 110' integriert sein kann, derart ansteuern, dass die elektrischen Verbinder 15 bis 17 die elektrischen Verbinder 12a und 12b gezielt miteinander verbunden werden können. Auf diese Weise können Eingabe-/Ausgabe-Funktionsmodule, die mit den ersten elektrischen Verbindern 15 bis 17 verbunden sind, in gezielter Weise miteinander und/oder über die zweiten elektrischen Verbinder 12 mit Eingabe-/Ausgabe-Funktionsmodulen benachbarter Basismodule 2 kommunizieren. Diese Kommunikation wird durch die elektronischen Einrichtungen 110' und den elektronischen Einrichtungen 120, die in den jeweiligen Eingabe-/Ausgabefunktionsmodul integriert sind, gesteuert. Alternativ kann die Rückwandleiterplatte 60 ein Koppelfeld aufweisen, dass die ersten elektrischen Verbinder 15-17 und die zweiten elektrischen Verbinder 12a und 12b fest miteinander verbindet.

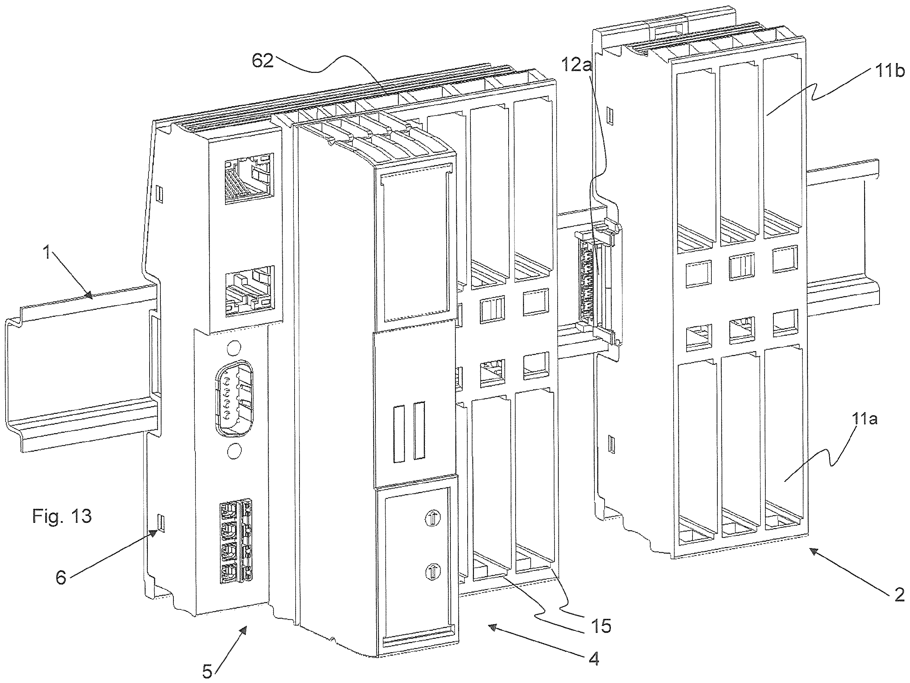

An das Basisblockmodul 6 kann ein Basismodul 2 mittels eines elektrischen Verbinders 12 angesteckt werden, wie in Fig. 13 dargestellt. So kann die Anzahl der elektrischen Verbinder 70a und 70b erweitert werden.

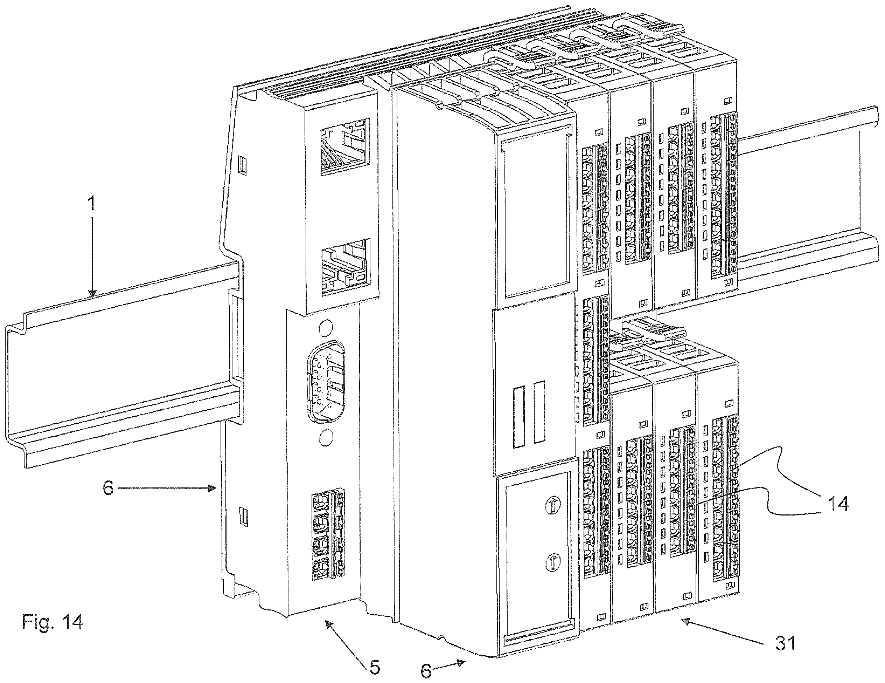

Fig. 14 zeigt das in Fig. 13 gezeigte Basisblockmodul 6 mit angekoppeltem Basismodul 2 und eingesetzten Eingabe-/Ausgabe-Funktionsmodulen, die eine komplette Eingabe/Ausgabe-Bus-Station als modularen Block bilden.

## Patentansprüche

1. Modulares Bussystem (100), umfassend
- eine Tragschiene (1), die eine Grundfläche (1a) und eine Längsachse aufweist,
- wenigstens ein an der Tragschiene (1) montierbares Basismodul (2) zum elektrischen Verbinden mit wenigstens einem Eingabe-/Ausgabe-Funktionsmodul (31-36), das eine Rückwandleiterplatte (21) aufweist, an der wenigstens eine Gruppe von wenigstens zwei ersten elektrischen Verbindern (70a, 70b) zur elektrischen Kopplung mit einem elektrischen Verbinder (23) eines Eingabe-/Ausgabe-Funktionsmoduls (31-36) angeschlossenen ist, wobei die wenigstens zwei ersten elektrischen Verbinder (70a, 70b) der wenigstens einen Gruppe auf einer gedachten Linie, die senkrecht zur Längsrichtung der Tragschiene (1) verläuft, hintereinander angeordnet sind und in einer Ebene liegen, in der die Grundfläche der Tragschiene liegt oder die parallel zur Grundfläche liegt,
- wenigstens ein Eingabe-/Ausgabe-Funktionsmodul (31-36), das einen elektrischen Verbinder (23) und eine elektronische Einrichtung (120) zur Kommunikation mit dem modularen Bussystem aufweist, wobei der elektrische Verbinder (23) des Eingabe-/Ausgabe- Funktionsmoduls (31-36) zum elektrischen Verbinden mit einem der elektrischen Verbinder (70a, 70b) des wenigstens einen Basismoduls (2) ausgebildet ist, wobei
an der Rückwandleiterplatte (21) des wenigstens einen Basismoduls (2) eine elektronische Einrichtung (110) angeordnet ist, die zur Kommunikation mit der elektronischen Einrichtung (120) des wenigstens einen Eingabe-Musgabe-Funktionsmoduls (31-36) ausgebildet ist, wobei an wenigstens einer Seite der Rückwandleiterplatte (21) des wenigstens einen Basismoduls (2), die senkrecht zur Längsachse der Tragschiene (1) verläuft, ein zweiter elektrischer Verbinder (12a) zur elektrischen Kopplung mit einem komplementären zweiten elektrischen Verbinder (12b) eines weiteren Basismoduls (2) vorgesehen ist, wobei der komplementäre zweite elektrische Verbinder (12b) an einer Seite einer Rückwandleiterplatte (21) des weiteren Basismoduls (2), die senkrecht zur Längsachse der Tragschiene (1) verläuft, angeordnet ist,
**dadurch gekennzeichnet, dass** die elektronische Einrichtung (110) des wenigstens einen Basismoduls (2) mit den ersten elektrischen Verbindern (70a, 70b) und dem wenigstens einen zweiten elektrischen Verbinder (12a) elektrisch verbunden ist und eine Auswerte- und Steuereinrichtung aufweist, welche dazu ausgebildet ist, zu erkennen, ob ein Eingabe-/Ausgabe-Funktionsmodul (31-36) an einem der ersten elektrischen Verbinder (70a, 70b) angeschlossen ist, und wenn ja, an welchem oder welchen ersten elektrischen Verbindern (70a, 70b) jeweils ein Eingabe-/Ausgabe-Funktionsmodul (31-36) angeschlossen ist.

2. Modulares Bussystem (100) nach Anspruch 1,
**dadurch gekennzeichnet, dass**
die elektronische Einrichtung (110) des wenigstens einen Basismoduls (2) dazu ausgebildet ist, die ersten elektrischen Verbinder (70a, 70b) und den wenigstens einen zweiten elektrischen Verbinder (12a) gezielt miteinander zu verbinden, so dass an das wenigstens eine Basismodul (2) angeschlossene Eingabe-/Ausgabe-Funktionsmodule (31-36) miteinander und/oder mit der elektronischen Einrichtung (110) und/oder mit Eingabe-/Ausgabe-Funktionsmodulen, welche an ein weiteres Basismoduls (2) angeschlossen sind, kommunizieren können.

3. Modulares Bussystem nach einem der vorstehenden Ansprüche,
**dadurch gekennzeichnet, dass**
das wenigstens eine Basismodul (2) einen Aufnahmekörper (90) aufweist, der wenigstens eine Gruppe von wenigstens zwei Aufnahmebereiche (11a, 11b) aufweist, wobei jeder Aufnahmebereich (11a, 11b) sich senkrecht zur Grundfläche (1a) der Tragschiene (1) erstreckt und dazu ausgebildet ist, ein Eingabe-/Ausgabe-Funktionsmodul (31-36) wenigstens teilweise aufzunehmen, wobei die wenigstens zwei Aufnahmebereiche (11a, 11b) der wenigstens einen Gruppe auf der gedachten Linie, die senkrecht zur Längsrichtung der Tragschiene (1) verläuft, und in der Ebene liegen, in der die Grundfläche (1a) der Tragschiene (1) liegt oder die parallel zur Grundfläche (1a) liegt, wobei die wenigstens zwei Aufnahmebereiche (11a, 11b) bezüglich der gedachten Linie hintereinander angeordnet sind, und wobei jeder Aufnahmebereich (11a, 11b) einem der ersten elektrischen Verbinder (70a, 70b) zugeordnet ist.

4. Modulares Bussystem (100) nach Anspruch 3,
**dadurch gekennzeichnet, dass**
das wenigstens eine Basismodul (2) eine an der Tragschiene (1) montierbare Trägerplatte (80) aufweist, die dazu ausgebildet ist, die Rückwandleiterplatte (21) und den Aufnahmekörper (90) zu tragen.

5. Modulares Bussystem nach einem der vorstehenden Ansprüche, weiterhin umfassend
ein Kopfmodul (4), das elektrisch mit einem Kopf-Basismodul (42) verbindbar ist, wobei das Kopf-Basismodul (42) einen elektrischen Verbinder (12a; 12b) zum elektrischen Verbinden mit dem wenigstens einen Basismodul (2) aufweist.

6. Modulares Bussystem nach Anspruch 5,
**dadurch gekennzeichnet, dass**
das Kopfmodul (4) zur Kommunikation mit den an dem wenigstens einen Basismodul (2) angeschlossenen Eingabe-/Ausgabe-Funktionsmodulen (31-36) ausgebildet ist.

7. Modulares Bussystem nach Anspruch 5 oder 6, weiterhin
umfassend
- einen Buskoppler (5), der über das Kopf-Basismodul (42) mit dem Kopfmodul (4) verbunden ist.

8. Modulares Bussystem nach Anspruch 7, wobei das Kopfmodul (4) und der Buskoppler (5) in fester Kombination ein Basisblockmodul (6) bilden, das ein Überbrückungs-Basismodul (62) enthält, welches eine Rückwandleiterplatte (60) mit einem elektrischen Verbinder (12) und/oder mit mehreren elektrischen Verbindern (15) zum Anschluss von Eingabe/Ausgabe-Funktionsmodulen und/oder drei weitere elektrische Verbinder (16, 17) zum Anschluss des Kopfmoduls (4) und/oder Netzwerkanschlüsse (51)und/oder einen Computeranschluss (52) und/oder einen sonstiger Anschluss (53) aufweist.

9. Modulares Bussystem nach einem der vorstehenden Ansprüche,
wobei mehrere Basismodule (2) bezüglich der Längsachse der Tragschiene (1) nebeneinander auf der Tragschiene (1) angeordnet sind.

## Claims

1. A modular bus system (100), comprising:
- a support rail (1) having a base surface (1a) and a longitudinal axis;
- at least one base module (2) mountable to the support rail (1) for electrical connection to at least one input/output functional module (31 - 36), which has a backplane circuit board (21) with at least one set of at least two first electrical connectors (70a, 70b) connected thereto, for electrical connection to an electrical connector (23) of an input/output functional module (31 - 36), wherein the at least two first electrical connectors (70a, 70b) of the at least one set are arranged one after the other along an imaginary line that extends perpendicular to the longitudinal direction of the support rail (1), and lie in the same plane as the base surface of the support rail or in a plane parallel to said base surface;
- at least one input/output functional module (31-36) comprising an electrical connector (23) and an electronic device (120) for communication with the modular bus system, wherein the electrical connector (23) of the input/output functional module (31 - 36) is configured to be electrically connected to one of the electrical connectors (70a, 70b) of the at least one base module (2); wherein
an electronic device (110) is arranged on the backplane circuit board (21) of the at least one base module (2), which is configured to communicate with the electronic device (120) of the at least one input/output functional module (31 - 36); wherein
on at least one side of the backplane circuit board (21) of the at least one base module (2), which extends perpendicular to the longitudinal axis of the support rail (1), a second electrical connector (12a) is provided for being electrically coupled to a complementary second electrical connector (12b) of a further base module (2), wherein said complementary second electrical connector (12b) is arranged on a side of a backplane circuit board (21) of the further base module (2), which extends perpendicular to the longitudinal axis of the support rail (1);
**characterised in that**
the electronic device (110) of the at least one base module (2) is electrically connected to the first electrical connectors (70a, 70b) and to the at least one second electrical connector (12a) and includes an evaluation and control device that is configured to detect whether an input/output functional module (31 - 36) is connected to any one of the first electrical connectors (70a, 70b), and if so, to which one or more of the first electrical connectors (70a, 70b) an input/output functional module (31 - 36) is connected to.

2. The modular bus system (100) according to claim 1,
**characterised in that**
the electronic device (110) of the at least one base module (2) is configured to selectively connect the first electrical connectors (70a, 70b) and the at least one second electrical connector (12a) to one another so that input/output functional modules (31 - 36) connected to the at least one base module (2) are able to communicate with one another and/or with the electronic device (110) and/or with input/output functional modules that are connected to a further base module (2).

3. The modular bus system according to any one of the preceding claims, **characterised in that**
the at least one base module (2) has a receptacle body (90) comprising at least one set of at least two receptacle regions (11a, 11b), wherein each receptacle region (11a, 11b) extends perpendicular to the base surface (1a) of the support rail (1) and is configured to at least partially accommodate a input/output functional module (31 - 36); wherein the at least two receptacle regions (11a, 11b) of the at least one set are provided along an imaginary line which extends perpendicular to the longitudinal direction of the support rail (1) and lie in the same plane as the base surface (1a) of the support rail (1) or in a plane parallel to the base surface (la), wherein the at least two receptacle regions (11a, 11b) are arranged one after the other with respect to said imaginary line; and wherein each receptacle area (11a, 11b) is associated with one of the first electrical connectors (70a, 70b).

4. The modular bus system (100) according to claim 3,
**characterised in that**
the at least one base module (2) comprises a support plate (80) which is mountable to the support rail (1) and configured to support the backplane circuit board (21) and the receptacle body (90).

5. The modular bus system according to any one of the preceding claims, further comprising
a header module (4) that is electrically connectable to a header base module (42), wherein the header base module (42) comprises an electrical connector (12a; 12b) for electrical connection to the at least one base module (2).

6. The modular bus system according to claim 5,
**characterised in that**
the header module (4) is configured to communicate with the input/output functional modules (31 - 36) that are connected to the at least one base module (2).

7. The modular bus system according to claim 5 or 6, further comprising
a bus coupler (5) which is connected to the header module (4) via said header base module (42).

8. The modular bus system according to claim 7,
wherein the header module (4) and the bus coupler (5), in a fixed combination, form a base block module (6) which comprises a bridging base module (62) that has a backplane circuit board (60) with an electrical connector (12) and/or with a plurality of electrical connectors (15) for connecting input/output functional modules (31 - 36), and/or with three further electrical connectors (16, 17) for connecting the header module (4), and/or network ports (51), and/or a computer port (52), and/or another port (53).

9. The modular bus system according to any one of the preceding claims,
wherein a plurality of base modules (2) are arranged side by side on the support rail (1) with respect to the longitudinal axis of the support rail (1).

## Revendications

1. Système de bus modulaire (100), comprenant
- un rail porteur (1), qui présente une surface de base (1a) et un axe longitudinal,
- au moins un module de base (2) pouvant être monté sur le rail porteur (1) et destiné à être relié électriquement à au moins un module fonctionnel d'entrée/sortie (31-36), qui présente une carte de fond de panier (21), à laquelle au moins un groupe d'au moins deux premiers connecteurs électriques (70a, 70b) est connecté pour le couplage électrique à un connecteur électrique (23) d'un module fonctionnel d'entrée/sortie (31-36), où les au moins deux premiers connecteurs électriques (70a, 70b) de l'au moins un groupe sont disposés l'un derrière l'autre sur une ligne imaginaire, qui s'étend perpendiculairement à la direction longitudinale du rail porteur (1), et se situent dans un plan dans lequel la surface de base du rail porteur se situe ou qui se situe parallèlement à la surface de base,
- au moins un module fonctionnel d'entrée/sortie (31-36), qui présente un connecteur électrique (23) et un dispositif électronique (120) pour la communication avec le système de bus modulaire, où le connecteur électrique (23) du module fonctionnel d'entrée/sortie (31-36) est conçu pour être relié électriquement à l'un des connecteurs électriques (70a, 70b) de l'au moins un module de base (2), où
un dispositif électronique (110), qui est conçu pour communiquer avec le dispositif électronique (120) de l'au moins un module fonctionnel d'entrée/sortie (31-36), est disposé sur la carte de fond de panier (21) de l'au moins un module de base (2), où un deuxième connecteur électrique (12a) destiné à être couplé électriquement à un deuxième connecteur électrique (12b) complémentaire d'un autre module de base (2), est prévu sur au moins une face de la carte de fond de panier (21) de l'au moins un module de base (2) , qui s'étend perpendiculairement à l'axe longitudinal du rail porteur (1), où le deuxième connecteur électrique (12b) complémentaire est disposé sur une face d'une carte de fond de panier (21) de l'autre module de base (2), qui est disposée perpendiculairement à l'axe longitudinal du rail porteur (1),
**caractérisé en ce que** le dispositif électronique (110) de l'au moins un module de base (2) est relié électriquement aux premiers connecteurs électriques (70a, 70b) et à l'au moins un deuxième connecteur électrique (12a) et présente un dispositif d'évaluation et de commande, lequel est conçu pour identifier si un module fonctionnel d'entrée/sortie (31-36) est connecté à l'un des premiers connecteurs électriques (70a, 70b), et si oui, auquel ou auxquels premiers connecteurs électriques (70a, 70b) respectivement un module fonctionnel d'entrée/sortie (31-36) est connecté.

2. Système de bus modulaire (100) selon la revendication 1, **caractérisé en ce que**
le dispositif électronique (110) de l'au moins un module de base (2) est conçu pour relier les premiers connecteurs électriques (70a, 70b) et l'au moins un deuxième connecteur électrique (12a) les uns aux autres de manière précise, de sorte que des modules fonctionnels d'entrée/sortie (31-36) connectés à l'au moins un module de base (2) peuvent communiquer les uns avec les autres et/ou avec le dispositif électronique (110) et/ou avec des modules fonctionnels d'entrée/sortie, lesquels sont connectés à un autre module de base (2).

3. Système de bus modulaire selon l'une quelconque des revendications précédentes, **caractérisé en ce que**
l'au moins un module de base (2) présente un corps de logement (90), qui présente au moins un groupe d'au moins deux zones de logement (11a, 11b), où chaque zone de logement (11a, 11b) s'étend perpendiculairement à la surface de base (1a) du rail porteur (1) et est conçue pour loger au moins en partie un module fonctionnel d'entrée/sortie (31-36), où les au moins deux zones de logement (11a, 11b) de l'au moins un groupe se situent sur la ligne imaginaire qui s'étend perpendiculairement à la direction longitudinale du rail porteur (1), et dans le plan dans lequel la surface de base (1a) du rail porteur (1) se situe ou qui se situe parallèlement à la surface de base (la), où les au moins deux zones de logement (11a, 11b) sont disposées l'une derrière l'autre par rapport à la ligne imaginaire, et où chaque zone de logement (11a, 11b) est associée à un des premiers connecteurs électriques (70a, 70b).

4. Système de bus modulaire (100) selon la revendication 3, **caractérisé en ce que**
l'au moins un module de base (2) présente une plaque porteuse (80) pouvant être montée sur le rail porteur (1), qui est conçue pour porter la carte de fond de panier (21) et le corps de logement (90).

5. Système de bus modulaire selon l'une quelconque des revendications précédentes, comprenant en outre
un module de tête (4), qui peut être relié électriquement à un module de base de tête (42), où le module de base de tête (42) présente un connecteur électrique (12a ; 12b) pour la liaison électrique à l'au moins un module de base (2).

6. Système de bus modulaire selon la revendication 5, **caractérisé en ce que**
le module de tête (4) est conçu pour communiquer avec les modules fonctionnels d'entrée/sortie (31-36) connectés à l'au moins un module de base (2).

7. Système de bus modulaire selon la revendication 5 ou 6, comprenant en outre
- un coupleur de bus (5), qui est relié au module de tête (4) par l'intermédiaire du module de base de tête (42).

8. Système de bus modulaire selon la revendication 7,
dans lequel le module de tête (4) et le coupleur de bus (5) forment en combinaison fixe un module de bloc de base (6), qui contient un module de base de pontage (62), lequel présente une carte de fond de panier (60) avec un connecteur électrique (12) et/ou avec plusieurs connecteurs électriques (15) pour la connexion de modules fonctionnels d'entrée/sortie et/ou trois autres connecteurs électriques (16, 17) pour la connexion du module de tête (4) et/ou connexions au réseau (51) et/ou une connexion à un ordinateur (52) et/ou une autre connexion (53).

9. Système de bus modulaire selon l'une quelconque des revendications précédentes,
dans lequel plusieurs modules de base (2) sont disposés les uns à côté des autres sur le rail porteur (1) par rapport à l'axe longitudinal du rail porteur (1).
